# EUROPÄISCHE PATENTSCHRIFT

(11) **EP 3 427 552 B1**
(45) Veröffentlichungstag und Bekanntmachung des Hinweises auf die Patenterteilung: **06.03.2024**
(21) Anmeldenummer: 17701690.4
(22) Anmeldetag: 25.01.2017
(51) Int. Cl.: H10N 30/80

(54) **VORRICHTUNG UND VERFAHREN ZUR ERZEUGUNG EINES NICHTTHERMISCHEN ATMOSPHÄRENDRUCK-PLASMAS**
APPARATUS AND METHOD FOR GENERATING A NON-THERMAL ATMOSPHERIC PRESSURE PLASMA
DISPOSITIF ET PROCÉDÉ SERVANT À PRODUIRE UN PLASMA À PRESSION ATMOSPHÉRIQUE NON THERMIQUE

(30) Priorität: 11.03.2016 DE 102016104490
(43) Veröffentlichungstag der Anmeldung: 16.01.2019
(73) Patentinhaber: TDK Electronics AG, 81671 München (DE)
(72) Erfinder: WEILGUNI, Michael, 4232 Hagenberg (AT); KUDELA, Pavol, 8530 Deutschlandsberg (AT)
(74) Vertreter: Epping - Hermann - Fischer
(86) Internationale Anmeldenummer: PCT/EP2017/051559
(87) Internationale Veröffentlichungsnummer: WO 2017/153084

(56) Entgegenhaltungen:
- DE-A1-102014 110 405
- US-A- 5 747 914
- US-A1- 2002 074 903
- US-A1- 2009 122 941

## Beschreibung

Die vorliegende Erfindung betrifft eine Vorrichtung zur Erzeugung eines nichtthermischen Atmosphärendruck-Plasmas sowie ein Verfahren zur Plasmaerzeugung.

Die Vorrichtung weist insbesondere einen ersten und einen zweiten piezoelektrischen Transformator auf, an deren Ausgangsseite ein hohes Potential erzeugt wird, das zur Ionisation eines Prozessgases genutzt werden kann. Das Volumen, auf welches das von einem piezoelektrischen Transformator erzeugte Plasma einwirken kann, ist Prinzip bedingt auf einen Bereich vor der Ausgangsseite des piezoelektrischen Transformators beschränkt. Insbesondere bei industriellen Anwendungen ist es häufig erforderlich, eine größere Fläche zu bearbeiten. Dementsprechend sollten hierfür mehrere piezoelektrische Transformatoren verwendet werden, die möglichst eng beieinander angeordnet werden sollten, ohne dass es dabei zu einer gegenseitigen Beeinträchtigung der Transformatoren kommt.

Aus EP 1902599 B1 ist es bekannt, mehrere in einem geringen Abstand zueinander angeordnete piezoelektrische Transformatoren mit einer um 180° phasenverschobenen Eingangsspannung zu betreiben. Dabei hat es sich jedoch gezeigt, dass eine gegenseitige Auslöschung der von den Transformatoren erzeugten Plasmen unvermeidlich ist.

US 2002/074903 A1 zeigt einen piezoelektrischen Transformator vom Rosen-Typ, dessen Eingangsbereich in zwei Teilbereiche unterteilt ist. Dabei kann an die Elektroden des ersten Teilbereichs eine erste Eingangsspannung angelegt werden und an die Elektroden des zweiten Teilbereichs kann eine zweite Eingangsspannung angelegt werden. Ferner weist der Transformator einen einzigen gemeinsamen Ausgangsbereich für die beiden Teilbereiche des Eingangsbereichs auf.

Aufgabe der vorliegenden Erfindung ist es nunmehr, eine verbesserte Vorrichtung zur Erzeugung eines nichtthermischen Atmosphärendruck-Plasmas anzugeben, die es insbesondere ermöglicht, mehrere piezoelektrische Transformatoren in geringem Abstand zueinander anzuordnen, ohne dass es zu einer Beeinträchtigung der Transformatoren untereinander kommt. Eine weitere Aufgabe ist es, ein verbessertes Verfahren zur Erzeugung von nichtthermischem Atmosphärendruck-Plasma anzugeben.

Diese Aufgaben werden durch die Vorrichtung gemäß dem vorliegenden Anspruch 1 sowie durch das Verfahren gemäß dem zweiten unabhängigen Anspruch 12 gelöst.

Es wird eine Vorrichtung zur Erzeugung eines nichtthermischen Atmosphärendruck-Plasmas vorgeschlagen, die einen ersten piezoelektrischen Transformator, einen zweiten piezoelektrischen Transformator und eine Ansteuerschaltung aufweist. Die Ansteuerschaltung ist dazu ausgestaltet, an jeden der piezoelektrischen Transformatoren eine Eingangsspannung anzulegen, wobei die Eingangsspannung, die an den ersten Transformator angelegt wird, gegenüber der Eingangsspannung, die an den zweiten Transformator angelegt wird, um 90° phasenverschoben ist.

Die Phasenverschiebung ist hierbei stets relativ angegeben. Dementsprechend kann die Angabe einer Phasenverschiebung von 90° als Betrag der Phasenverschiebung betrachtet werden, sofern nicht explizit auf eine positive Phasenverschiebung von +90° oder eine negative Phasenverschiebung von -90° hingewiesen wird.

Werden die beiden piezoelektrischen Transformatoren mit einer um 90° zueinander verschobenen Eingangsspannung betrieben, so erfolgt eine Plasmagenerierung stets abwechselnd bei dem ersten piezoelektrischen Transformator und bei dem zweiten piezoelektrischen Transformator. Auf diese Weise kann vermieden werden, dass die beiden Transformatoren gleichzeitig Plasma generieren, wodurch die beiden Plasmagenerierungen einander beeinträchtigen würden. Durch ein abwechselndes Erzeugen des Plasmas mit dem ersten und dem zweiten Transformator kann insgesamt eine verbesserte Plasmagenerierungsrate erzielt werden.

Der erste und der zweite piezoelektrische Transformator können in einem Abstand von weniger als 5 cm zueinander angeordnet sein. Der geringe Abstand der Transformatoren wird dadurch ermöglicht, dass die beiden Transformatoren einander bei der Plasmagenerierung nicht stören. Die beiden Transformatoren sollten einen Abstand von zumindest 5 mm zueinander aufweisen.

Die Ansteuerschaltung kann derart ausgestaltet sein, dass die Eingangsspannungen, die an die piezoelektrischen Transformatoren angelegt werden, jeweils die gleiche Frequenz aufweisen. Andernfalls würden die Eingangsspannungen aufgrund einer sich unterscheidenden Frequenz auseinanderlaufen, sodass eine Phasenverschiebung von 90° nicht im Dauerbetrieb eingehalten werden könnte. Außerdem würde es in diesem Fall eine Schwebung und entsprechende Schwebungseffekte geben. Dadurch, dass die Transformatoren mit der gleichen Frequenz angesteuert werden, kann das Ausbilden einer Schwebung vermieden werden.

Die Transformatoren können mittels eines Schleifverfahrens auf die gleiche Länge und somit die gleiche Resonanzfrequenz getrimmt werden. Alternativ kann zur Ansteuerung der Transformatoren eine Frequenz gewählt werden, die sich aus dem Mittelwert der Resonanzfrequenzen der piezoelektrischen Transformatoren der Vorrichtung ergibt.

Die Vorrichtung kann ferner weitere piezoelektrische Transformatoren aufweisen, wobei die Ansteuerschaltung dazu ausgelegt sein kann, die Eingangsspannungen an die Transformatoren derart anzulegen, dass Eingangsspannungen, die an zueinander unmittelbar benachbarten Transformatoren anliegen, jeweils um 90° zueinander phasenverschoben sind.

Durch die Verwendung weiterer piezoelektrischer Transformatoren kann es ermöglicht werden, mit der Vorrichtung eine große Fläche zu bearbeiten, wobei durch eine Erhöhung der Anzahl der piezoelektrischen Transformatoren die gleichzeitig bearbeitbare Fläche vergrößert wird.

Die piezoelektrischen Transformatoren können parallel zueinander angeordnet sein und eine einzige Zeile bilden.

Die piezoelektrischen Transformatoren können parallel zueinander angeordnet sein und ein Array mit zumindest zwei Zeilen und zumindest zwei Spalten bilden. Die Ansteuerschaltung kann dazu ausgelegt sein, die Eingangsspannungen an die Transformatoren derart anzulegen, dass die Eingangsspannungen, die an den Transformatoren anliegen, die auf ein und derselben Diagonale des Arrays angeordnet sind, jeweils um 0° zueinander phasenverschoben sind.

Der erste und der zweite piezoelektrische Transformator können derart angeordnet sein, dass ihre ausgangsseitigen Stirnseiten einander gegenüberliegen. Dabei kann ein zu bearbeitender Gegenstand, beispielsweise eine Folie, durch einen Spalt, der zwischen den ausgangsseitigen Stirnseiten der beiden Transformatoren ausgebildet ist, hindurchgeführt werden. Dementsprechend können zwei einander gegenüberliegende Oberflächen des Gegenstandes gleichzeitig mit von der Vorrichtung erzeugten Plasma beaufschlagt werden.

Alternativ oder ergänzend kann die Vorrichtung eine erste Gruppe von piezoelektrischen Transformatoren, die den ersten piezoelektrischen Transformator und weitere piezoelektrische Transformatoren aufweist, die parallel zueinander angeordnet sind und eine einzige Zeile bilden, und eine zweite Gruppe von piezoelektrischen Transformatoren, die den zweiten piezoelektrischen Transformator und weitere piezoelektrische Transformatoren aufweist, die parallel zueinander angeordnet sind und eine einzige Zeile bilden, aufweisen. Die erste Gruppe von piezoelektrischen Transformatoren und die zweite Gruppe von piezoelektrischen Transformatoren können einander gegenüberliegend angeordnet sein, wobei die Ansteuerschaltung dazu ausgelegt ist, die Eingangsspannungen an die Transformatoren einer Zeile jeweils derart anzulegen, dass Eingangsspannungen, die an zueinander unmittelbar benachbarten Transformatoren anliegen, jeweils um 90° zueinander phasenverschoben sind, und dass ferner die Eingangsspannungen, die an einander gegenüberliegenden Transformatoren anliegen, jeweils um 90° zueinander phasenverschoben sind.

Alternativ oder ergänzend kann die Vorrichtung eine erste Gruppe von piezoelektrischen Transformatoren, die den ersten piezoelektrischen Transformator und weitere piezoelektrische Transformatoren aufweist, die parallel zueinander angeordnet sind und ein Array mit zumindest zwei Spalten und zumindest zwei Zeilen bilden, und eine zweite Gruppe von piezoelektrischen Transformatoren, die den zweiten piezoelektrischen Transformator und weitere piezoelektrische Transformatoren aufweist, die parallel zueinander angeordnet sind und ein Array mit zumindest zwei Spalten und zumindest zwei Zeilen bilden, aufweisen. Die erste Gruppe von piezoelektrischen Transformatoren und die zweite Gruppe von piezoelektrischen Transformatoren können einander gegenüberliegend angeordnet sein, wobei die Ansteuerschaltung dazu ausgelegt ist, die Eingangsspannungen an die Transformatoren jeweils derart anzulegen, dass Eingangsspannungen, die an zueinander unmittelbar benachbarten Transformatoren anliegen, jeweils um 90° zueinander phasenverschoben sind, dass die Eingangsspannungen, die an den Transformatoren anliegen, die auf ein und derselben Diagonale des Arrays angeordnet sind, jeweils um 0° zueinander phasenverschoben sind, und dass ferner die Eingangsspannungen, die an einander gegenüberliegenden Transformatoren anliegen, jeweils um 90° zueinander phasenverschoben sind.

Gemäß einem weiteren Aspekt betrifft die vorliegende Erfindung ein Verfahren zur Erzeugung eines nichtthermischen Atmosphärendruck-Plasmas mittels zumindest eines ersten piezoelektrischen Transformators und eines zweiten piezoelektrischen Transformators, wobei an dem ersten piezoelektrischen Transformator und an dem zweiten piezoelektrischen Transformator jeweils eine Eingangsspannung angelegt wird, die zueinander um 90° phasenverschoben ist.

Das Verfahren kann insbesondere mit der oben beschriebenen Vorrichtung durchgeführt werden. Dementsprechend kann jedes funktionelle und strukturelle Merkmal, das im Zusammenhang mit der Vorrichtung offenbart wurde, auch auf das Verfahren zutreffen.

Im Folgenden wird die vorliegende Erfindung anhand der Figuren näher erläutert.
- Figur 1: zeigt einen piezoelektrischen Transformator in perspektivischer Ansicht.
- Figuren 2A bis 2C: zeigen eine Plasmagenerierung mit zwei piezoelektrischen Transformatoren, wobei in den Figuren jeweils die an die Transformatoren angelegten Eingangsspannungen in ihrer Phasenverschiebung zueinander variiert sind.
- Figuren 3 und 4: zeigen den Verlauf der an den ausgangsseitigen Stirnseiten der Transformatoren erzeugten Ausgangsspannung.
- Figur 5: zeigt eine Vorrichtung zur Plasmaerzeugung, bei der piezoelektrische Transformatoren in einer einzigen Zeile angeordnet sind.
- Figur 6: zeigt ein Array aus piezoelektrischen Transformatoren.
- Figur 7: zeigt eine Vorrichtung zur Plasmaerzeugung, bei der die piezoelektrischen Transformatoren einander gegenüberliegen.

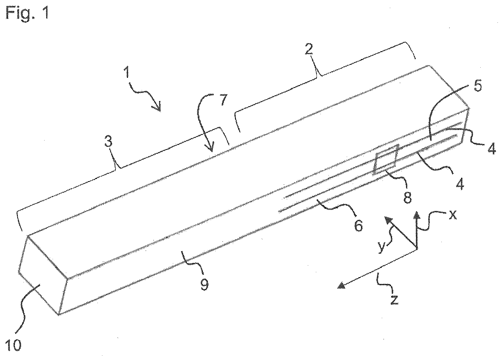

Figur 1 zeigt einen piezoelektrischen Transformator 1 in einer perspektivischen Ansicht. Der piezoelektrische Transformator 1 kann insbesondere in einer Vorrichtung zur Erzeugung von nichtthermischem Atmosphärendruck-Plasma eingesetzt werden.

Ein piezoelektrischer Transformator 1 ist eine Bauform eines Resonanztransformators, welcher auf Piezoelektrizität basiert und im Gegensatz zu den herkömmlichen magnetischen Transformatoren ein elektromechanisches System darstellt. Der piezoelektrische Transformator 1 ist beispielsweise ein Transformator vom Rosen-Typ.

Der piezoelektrische Transformator 1 weist einen Eingangsbereich 2 und einen Ausgangsbereich 3 auf, wobei der Ausgangsbereich 3 sich in einer longitudinalen Richtung z an den Eingangsbereich 2 anschließt. Im Eingangsbereich 2 weist der piezoelektrische Transformator 1 Elektroden 4 auf, an die eine Wechselspannung angelegt werden kann. Die Elektroden 4 erstrecken sich in der longitudinalen Richtung z des piezoelektrischen Transformators 1. Die Elektroden 4 sind in einer Stapelrichtung x, die senkrecht zu der longitudinalen Richtung z ist, abwechselnd mit einem piezoelektrischen Material 5 gestapelt. Das piezoelektrische Material 5 ist dabei in Stapelrichtung x polarisiert.

Die Elektroden 4 sind im Innern des piezoelektrischen Transformators 1 angeordnet und werden auch als Innenelektroden bezeichnet. Der piezoelektrische Transformator 1 weist eine erste Seitenfläche 6 und eine zweite Seitenfläche 7, die der ersten Seitenfläche 6 gegenüberliegt, auf. Auf der ersten Seitenfläche 6 ist eine erste Außenelektrode 8 angeordnet. Auf der zweiten Seitenfläche 7 ist eine zweite Außenelektrode (nicht gezeigt) angeordnet. Die innenliegenden Elektroden 4 sind in Stapelrichtung x abwechselnd entweder mit der ersten Außenelektrode 8 oder der zweiten Außenelektrode elektrisch kontaktiert.

Ferner weist der piezoelektrische Transformator 1 eine dritte Seitenfläche 20 und eine vierte Seitenfläche 21 auf, die einander gegenüberliegen und die senkrecht zu der ersten Seitenfläche 6 und der zweiten Seitenfläche 7 angeordnet sind. Die Flächennormalen der dritten und der vierten Seitenflächen 20, 21 zeigen jeweils in Stapelrichtung x.

Der Eingangsbereich 2 kann mit einer geringen Wechselspannung angesteuert werden, die zwischen den Elektroden 4 angelegt wird. Aufgrund des piezoelektrischen Effekts wird die eingangsseitig angelegte Wechselspannung zunächst in eine mechanische Schwingung umgewandelt. Die Frequenz der mechanischen Schwingung ist dabei wesentlich von der Geometrie und dem mechanischen Aufbau des piezoelektrischen Transformators 1 abhängig.

Der Ausgangsbereich 3 weist piezoelektrisches Material 9 auf und ist frei von innenliegenden Elektroden. Das piezoelektrische Material 9 im Ausgangsbereich ist in der longitudinalen Richtung z polarisiert. Bei dem piezoelektrischen Material 9 des Ausgangsbereichs 3 kann es sich um das gleiche Material wie bei dem piezoelektrischen Material 5 des Eingangsbereichs 2 handeln, wobei sich die piezoelektrischen Materialien 5 und 9 in ihrer Polarisationsrichtung unterscheiden können. Im Ausgangsbereich 3 ist das piezoelektrische Material 9 zu einer einzigen monolithischen Schicht geformt, die vollständig in der longitudinalen Richtung z polarisiert ist. Dabei weist das piezoelektrische Material 9 im Ausgangsbereich 3 nur eine einzige Polarisationsrichtung auf.

Wird an die Elektroden 4 im Eingangsbereich 2 eine Wechselspannung angelegt, so bildet sich innerhalb des piezoelektrischen Materials 5, 9 eine mechanische Welle aus, die durch den piezoelektrischen Effekt im Ausgangsbereich 3 eine Ausgangsspannung erzeugt. Der Ausgangsbereich 3 weist eine ausgangsseitige Stirnseite 10 auf. Im Ausgangsbereich 3 wird somit eine elektrische Spannung zwischen der Stirnseite 10 und dem Ende der Elektroden 4 des Eingangsbereichs 2 erzeugt. An der ausgangsseitigen Stirnseite 10 wird dabei eine Hochspannung erzeugt. Dabei entsteht auch zwischen der ausgangseitigen Stirnseite und einer Umgebung des piezoelektrischen Transformators eine hohe Potentialdifferenz, die ausreicht, um ein starkes elektrisches Feld zu erzeugen, dass ein Prozessgas ionisiert.

Auf diese Weise erzeugt der piezoelektrische Transformator 1 hohe elektrische Felder, die in der Lage sind, Gase oder Flüssigkeiten durch elektrische Anregung zu ionisieren. Dabei werden Atome oder Moleküle des jeweiligen Gases bzw. der jeweiligen Flüssigkeit ionisiert und bilden ein Plasma. Es kommt immer dann zu einer Ionisation, wenn die elektrische Feldstärke an der Oberfläche des piezoelektrischen Transformators 1 die Zündfeldstärke des Plasmas überschreitet. Als Zündfeldstärke eines Plasmas wird dabei die Feldstärke bezeichnet, die zur Ionisation der Atome oder Moleküle erforderlich ist.

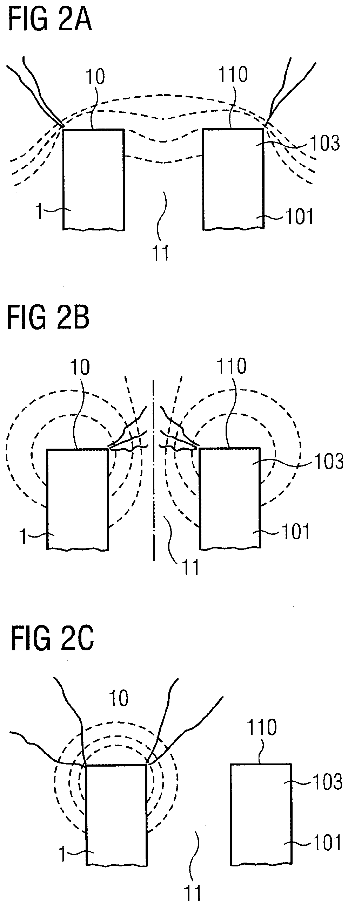

Die Figuren 2A bis 2C zeigen schematisch die Plasmaerzeugung mittels einer Vorrichtung, die einen ersten piezoelektrischen Transformator 1 und einen zweiten piezoelektrischen Transformator 101 aufweist. Ferner weist die Vorrichtung eine Ansteuerschaltung auf, die es ermöglicht, an jeden der beiden Transformatoren 1, 101 eine Eingangsspannung anzulegen.

Der erste Transformator 1 und der zweite Transformator 101 sind parallel zueinander angeordnet. Insbesondere ist der Ausgangsbereich 3 des ersten Transformators 1 unmittelbar benachbart zu einem Ausgangsbereich 103 des zweiten Transformators 101 angeordnet. Die Flächennormalen der ausgangsseitigen Stirnseite 10 des ersten Transformators und einer ausgangsseitige Stirnseite 110 des zweiten Transformators 101 sind zueinander parallel. Zwischen dem ersten Transformator 1 und dem zweiten Transformator 101 befindet sich ein Spalt 11.

Durch die Verwendung mehrerer piezoelektrischer Transformatoren 1, 101 in einer Vorrichtung zur Erzeugung eines nichtthermischen Atmosphärendruck-Plasmas wird es ermöglicht, gleichzeitig eine größere Fläche mit einem Plasma zu bearbeiten. Insbesondere bei industriellen Anwendungen ist es für eine effiziente Prozessgestaltung wesentlich, dass große Flächen in einer kurzen Bearbeitungszeit mit nichtthermischem Atmosphärendruck-Plasma beaufschlagt werden können.

Figur 2A zeigt eine nicht-erfindungsgemäße Anordnung, bei der an die beiden Transformatoren 1, 101 jeweils eine Eingangsspannung angelegt wird, wobei die an dem ersten Transformator 1 anliegende Eingangsspannung und die an dem zweiten Transformator 101 anliegende Eingangsspannung nicht zueinander phasenverschoben sind. An jeden der beiden Transformatoren 1, 101 wird dabei eine sinusförmige Eingangsspannung angelegt. Dementsprechend weist der zeitliche Verlauf des an den ausgangsseitigen Stirnseiten 10 110 erzeugten Potentials ebenfalls einen sinusförmigen Verlauf auf, wobei an beiden Transformatoren 1, 101 zum gleichen Zeitpunkt ein maximales Potential erzeugt wird.

Durch gestrichelte Linien ist in Figur 2A der Feldverlauf der von den beiden Transformatoren 1, 101 erzeugten Potentiale angedeutet. Die gestrichelten Linien sind dabei jeweils Äquipotentiallinien.

Figur 2A betrachtet den Potentialverlauf zu einem Zeitpunkt, an dem an beiden Transformatoren 1, 101 an der jeweiligen ausgangsseitigen Stirnseite 10, 110 ein maximales Potential erzeugt wird. Es ergibt sich ein Potentialverlauf, bei dem das Potential in dem Spalt 11 zwischen den beiden Transformatoren 1, 101 annähernd konstant bleibt. Ein hoher Feldgradient stellt sich dagegen an den Kanten der ausgangsseitigen Stirnseiten 10, 110 ein, die von dem Spalt 11 wegweisen. Hier liegen die gestrichelt eingezeichneten Äquipotentiallinien eng beieinander.

Zur Zündung eines Plasmas ist ein hoher Feldgradient erforderlich. Dementsprechend ergibt sich bei einer phasengleichen Ansteuerung der beiden piezoelektrischen Transformatoren 1, 101 bei der Plasmagenerierung das folgende Bild: Im Bereich des Spalts 11 zwischen den beiden Transformatoren 1, 101 wird auf Grund der Nivellierung des Potentials kein Plasma gezündet. Lediglich an den Kanten der ausgangsseitigen Stirnseiten 10, 110, die von dem Spalt 11 wegweisen, kommt es zu einer Plasmazündung, da nur hier ein ausreichend hoher Feldgradient vorliegt.

Die mit dieser Ansteuerung der piezoelektrischen Transformatoren 1, 101 erzeugbare Plasmamenge ist nicht wesentlich höher als die mit einem einzigen piezoelektrischen Transformator 1 erreichbare Menge an Plasma.

Figur 2B zeigt eine weitere nicht-erfindungsgemäße Ansteuerung der beiden piezoelektrischen Transformatoren 1, 101. Hierbei wird an jeden der beiden piezoelektrischen Transformatoren 1, 101 jeweils eine sinusförmige Eingangsspannung angelegt, die zueinander um 180° phasenverschoben sind.

Dementsprechend liegt an der ausgangseitigen Stirnseite 10 des ersten piezoelektrischen Transformators 1 ein maximal positives Potential vor, wenn zum gleichen Zeitpunkt an der ausgangseitigen Stirnseite 110 des zweiten piezoelektrischen Transformators 101 ein maximal negatives Potential vorliegt.

In diesem Fall stellt sich ein hoher Feldgradient insbesondere in dem Spalt 11 zwischen den beiden piezoelektrischen Transformatoren 1, 101 ein. Dementsprechend kommt es zu einer Plasmazündung am ersten piezoelektrischen Transformator 1, bei der ein Plasmastrahl generiert wird, der stark zum zweiten piezoelektrischen Transformator 101 hingerichtet ist. Bei dem zweiten piezoelektrischen Transformator 101 kommt es zu einer Plasmazündung, bei der ein Plasmastrahl generiert wird, der stark zum ersten piezoelektrischen Transformator 1 hingerichtet ist.

An den Kanten der ausgangsseitigen Stirnseiten 10, 110, die von dem Spalt 11 wegweisen, stellt sich im Vergleich zu dem Spalt 11 ein geringerer Feldgradient ein. Daher kommt es an diesen Kanten nicht zu einer Plasmazündung. Insgesamt ist daher die in diesem Fall erzeugte Plasmamenge nicht wesentlich höher ist als die in der gleichen Zeit mit einem einzigen piezoelektrischen Transformator 1 erzeugbare Plasmamenge.

Figur 2C betrachtet nunmehr eine Ansteuerung, bei der an den ersten piezoelektrischen Transformator 1 eine Eingangsspannung angelegt wird, die um 90° phasenverschoben ist gegenüber einer Eingangsspannung, die an den zweiten piezoelektrischen Transformator 101 angelegt wird. Die beiden Eingangsspannungen weisen jeweils einen sinusförmigen Verlauf auf.

In diesem Fall erreicht das an der ausgangsseitigen Stirnseite 10 des ersten piezoelektrischen Transformators 1 erzeugte Potential sein Maximum, wenn der zweite piezoelektrische Transformator 101 quasi feldfrei ist. Dementsprechend wird die Plasmagenerierung durch den ersten piezoelektrischen Transformator 1 von dem zweiten piezoelektrischen Transformator 101 nicht wesentlich beeinflusst.

Ferner erreicht das an der ausgangsseitigen Stirnseite 110 des zweiten piezoelektrischen Transformators 101 erzeugte Potential ein Maximum, wenn der erste piezoelektrische Transformator 1 quasi feldfrei ist. Dementsprechend wird auch die Plasmagenerierung durch den zweiten piezoelektrischen Transformator 101 von dem ersten piezoelektrischen Transformator 1 nicht wesentlich beeinflusst.

Die in Figur 2C beschriebene Konfiguration führt dementsprechend zu einer Plasmagenerierungsrate, die wesentlich größer ist als eine mit einem einzigen piezoelektrischen Transformator 1 erreichbare Plasmagenerierungsrate. Ferner wird das erzeugte Plasma in eine Richtung nach vorne gleichmäßig über einen großen Raumwinkel erzeugt.

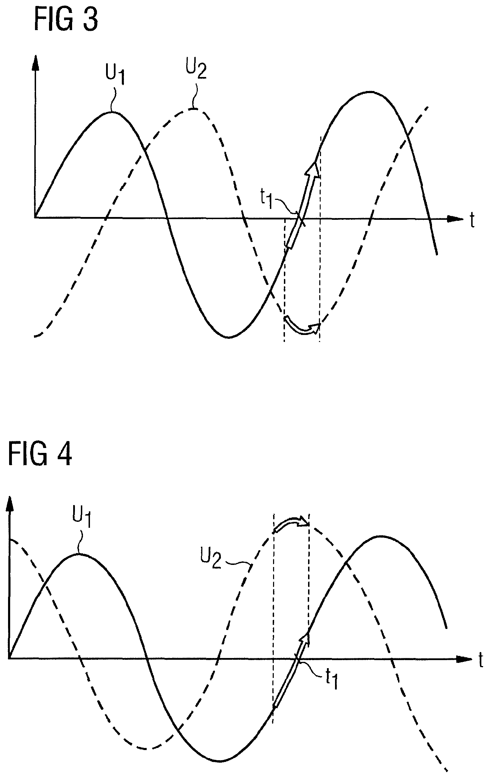

Figur 3 zeigt den zeitlichen Verlauf des an der ausgangsseitigen Stirnseite 10 des ersten piezoelektrischen Transformators 1 erzeugten Potentials sowie des an der ausgangsseitigen Stirnseite 110 des zweiten piezoelektrischen Transformators 101 erzeugten Potentials. Die Kurve U₁ zeigt dabei den zeitlichen Verlauf des an der ausgangsseitigen Stirnseite 10 des ersten piezoelektrischen Transformators 1 erzeugten Potentials und die Kurve U₂ zeigt entsprechend den zeitlichen Verlauf des an der ausgangsseitigen Stirnseite 110 des zweiten piezoelektrischen Transformators 101 erzeugten Potentials. Die an den zweiten piezoelektrischen Transformator 101 angelegte Eingangsspannung ist um +90° gegenüber der an den ersten piezoelektrischen Transformator 1 angelegten Eingangsspannung phasenverschoben.

Plasma und Ozon können von dem piezoelektrischen Transformator 1 durch eine Dielektrische Barriereentladung (DBD = Dielectric Barrier Discharge) erzeugt werden. Die Plasmagenerierung in Folge einer Dielektrischen Barriereentladung hängt weitgehend von der Änderungsgeschwindigkeit des an der ausgangsseitigen Stirnseite 10, 110 erzeugten Potentials ab. Sind nun, wie in Figur 3 gezeigt, die an zwei unmittelbar zueinander benachbarten piezoelektrischen Transformatoren 1, 101 erzeugten Potential um 90° zueinander verschoben, so zeigen die Potentiale jeweils abwechselnd eine maximale Änderungsgeschwindigkeit.

Beispielsweise weist die Kurve U₁ zum Zeitpunkt t₁ eine maximale Anstiegsgeschwindigkeit auf. Die Kurve U₂ weist dagegen zum Zeitpunkt t₁ eine nur minimale Änderung auf. Dementsprechend wird zum Zeitpunkt t₂ am ersten piezoelektrischen Transformator 1 ein Plasma gezündet und am zweiten piezoelektrischen Transformator 101 kein Plasma gezündet. Da somit die beiden Transformatoren 1, 101 stets abwechselnd zueinander Plasma generieren, stören sie gegenseitig die Plasmagenerierung nicht.

Figur 4 zeigt ebenfalls den Verlauf der an den ausgangsseitigen Stirnseiten 10, 110 des ersten und des zweiten piezoelektrischen Transformators 1, 101 erzeugten Potentiale, wobei nunmehr die Eingangsspannung des zweiten piezoelektrischen Transformators 101 um -90° gegenüber der Eingangsspannung des ersten piezoelektrischen Transformators 1 phasenverschoben ist. Wiederum stellt sich die bereits in Figur 3 erläuterte Konfiguration ein, bei der die beiden Transformatoren 1, 101 stets abwechselnd zueinander Plasma generieren, da sie jeweils dann ein Maximum der Anstiegsgeschwindigkeit der ausgangseitigen Potentiale erreichen, wenn der jeweils andere Transformator 1, 101 ein nahezu konstantes Potential zeigt.

Somit ermöglicht es eine um 90° versetzte Ansteuerung der beiden Transformatoren 1, 101 sowohl den geometrischen Feldgradienten als auch den zeitlichen Verlauf der Änderungsgeschwindigkeit der erzeugten Felder derart zu optimieren, dass die von den beiden Transformatoren 1, 101 erzeugte Plasmamenge maximiert werden kann.

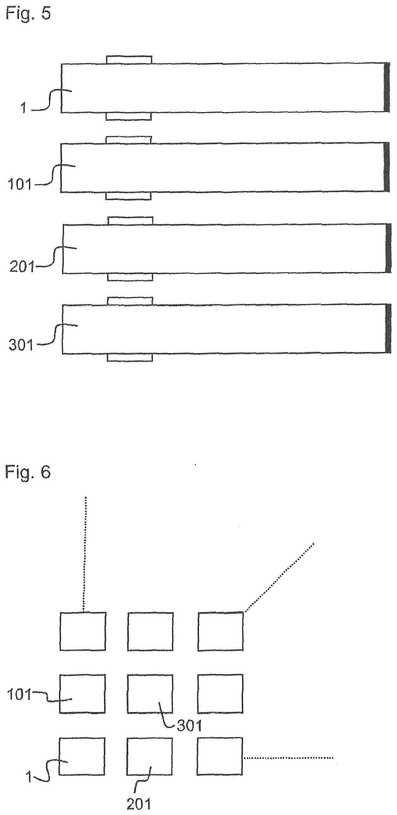

Figur 5 zeigt eine Vorrichtung zur Erzeugung eines nichtthermischen Atmosphärendruck-Plasmas, die neben dem ersten piezoelektrischen Transformator 1 und dem zweiten piezoelektrischen Transformator 101 einen dritten Transformator 201 und einen vierten Transformator 301 aufweist. Ferner kann die Vorrichtung noch weitere piezoelektrische Transformatoren aufweisen. Die piezoelektrischen Transformatoren 1, 101, 201, 301 sind dabei parallel zueinander angeordnet. Die Flächennormalen der ausgangsseitigen Stirnseiten der piezoelektrischen Transformatoren sind parallel zueinander.

Ferner sind die piezoelektrischen Transformatoren 1, 101, 201, 301 in einem geringen Abstand zueinander angeordnet. Die piezoelektrischen Transformatoren 1, 101, 201, 301 können in einem Abstand von mehr als 5 mm und weniger als 5 cm zueinander angeordnet sein. Die piezoelektrischen Transformatoren 1, 101, 201, 301 sind derart angeordnet, dass sie eine Zeile bilden. Diese Anordnung von piezoelektrischen Transformatoren 1, 101, 201, 301 in einer einzigen Zeile ermöglicht es, beispielsweise Folien auf Fließbändern effektiv mit Plasma zu beaufschlagen.

Der erste Transformator 1 ist unmittelbar zu dem zweiten Transformator 101 benachbart. Der zweite Transformator 101 ist unmittelbar zu dem ersten Transformator 1 und zu dem dritten Transformator 201 benachbart, usw.

Die Vorrichtung weist ferner eine Ansteuerschaltung auf, die an jeden der piezoelektrischen Transformatoren 1, 101, 201, 301 eine Eingangsspannung anlegt. Dabei werden die Eingangsspannungen derart angelegt, dass an jeweils zueinander benachbarte piezoelektrische Transformatoren Eingangsspannungen angelegt werden, die um jeweils 90° zueinander phasenverschoben sind.

Als Beispiel wird nunmehr eine Ansteuerung des ersten bis eines vierten piezoelektrischen Transformators 1, 101, 201, 301 betrachtet.

Gemäß einem ersten Ausführungsbeispiel könnte die Ansteuerschaltung an den ersten und den dritten piezoelektrischen Transformator 1, 201 jeweils eine identische Eingangsspannung, das heißt Eingangsspannungen, die nicht gegeneinander phasenverschoben sind, anlegen und an dem zweiten und vierten piezoelektrischen Transformator 101, 301 jeweils eine Eingangsspannung anlegen, die um 90° gegenüber der an dem ersten und dritten Transformator 1, 101 anliegenden Eingangsspannung phasenverschoben ist.

Gemäß einem zweiten Ausführungsbeispiel weist die Eingangsspannung des ersten Transformators 1 eine Phasenverschiebung von 0°, die Eingangsspannung des zweiten Transformators 101 und des vierten Transformators 301 jeweils eine Phasenverschiebung von +90° und die Eingangsspannung des dritten Transformators 201 eine Phasenverschiebung von +180° auf. Weitere mögliche Phasenverschiebungen der an dem ersten bis vierten piezoelektrischen Transformator 1, 101, 201, 301 angelegten Eingangsspannungen können der untenstehenden Tabelle entnommen werden. Die Phasenverschiebungen sind dabei stets relativ zueinander zu sehen. Dementsprechend sind auch sämtliche Permutationen mit positiven und negativen Vorzeichen sowie um n° verschobene Phasenverschiebungen möglich.

| | Erster Transformator | zweiter Transformator | Dritter Transformator | Vierter Transformator |
|---|---|---|---|---|
| Beispiel 1 | 0° | +90° | 0° | +90° |
| Beispiel 2 | 0° | +90° | +180° | +90° |
| Beispiel 3 | 0° | +90° | 0° | -90° |
| Beispiel 4 | 0° | +90° | +180° | +270° |

In der Tabelle sind jeweils die Phasenverschiebungen der an den ersten bis vierten piezoelektrischen Transformator 1, 101, 201, 301 angelegten Eingangsspannungen aufgeführt. Die Phasenverschiebungen sind dabei stets relativ zueinander zu sehen. Dementsprechend sind auch sämtliche Permutationen mit positiven und negativen Vorzeichen möglich. Ferner sind sämtliche Verschiebungen inkludiert, bei denen alle Phasenverschiebungen um einen beliebigen Betrag n° verschoben werden.

Figur 6 zeigt ein weiteres Ausführungsbeispiel der Vorrichtung. Dabei sind die ausgangsseitigen Stirnseiten 10, 110 der piezoelektrischen Transformatoren 1, 101, 201, 301 der Vorrichtung in Draufsicht gezeigt. Die piezoelektrischen Transformatoren sind parallel zueinander angeordnet und bilden ein Array 1, 101, 201, 301, das mehrere Zeilen und mehrere Spalten aufweist. Beispielsweise sind der erste und der dritte Transformator 1, 201 in einer Zeile angeordnet. Der erste und der zweite Transformator 1, 101 sind in einer Spalte angeordnet. Der erste und der vierte Transformator 1, 301 sind entlang derselben Diagonale angeordnet. Auch der zweite und der dritte Transformator 101, 201 sind entlang derselben Diagonale angeordnet.

Die Transformatoren 1, 101, 201, 301 werden derart angesteuert, dass unmittelbar zueinander benachbarte piezoelektrische Transformatoren 1, 101 jeweils mit einer Eingangsspannung versorgt werden, die um 90° zueinander phasenverschoben ist. Die piezoelektrischen Transformatoren 1, 301 bzw. 101, 201, die auf einer Diagonale liegen, werden jeweils mit einer Eingangsspannung versorgt, die nicht gegeneinander phasenverschoben ist. Dadurch kann das Zünden von Plasma entlang der Diagonalen verhindert werden.

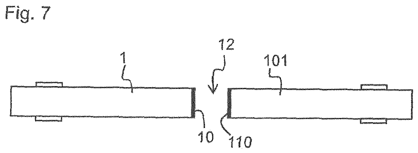

Figur 7 zeigt ein weiteres Ausführungsbeispiel einer Vorrichtung zur Erzeugung eines nichtthermischen Atmosphärendruck-Plasmas. Der erste piezoelektrische Transformator 1 und der zweite piezoelektrische Transformator 101 sind hierbei einander gegenüberliegend angeordnet. Insbesondere weist die ausgangsseitige Stirnseite 10 des ersten piezoelektrischen Transformators 1 zur ausgangsseitigen Stirnseite 110 des zweiten piezoelektrischen Transformators 101 hin.

Auch in diesem Fall werden die beiden piezoelektrischen Transformatoren 1, 101 von einer Ansteuerschaltung mit einer Eingangsspannung derart versorgt, dass die an dem ersten piezoelektrischen Transformator 1 anliegende Eingangsspannung um 90° gegenüber der an dem zweiten piezoelektrischen Transformator 101 anliegenden Eingangsspannung um 90° phasenverschoben ist.

Die in Figur 7 gezeigte Vorrichtung eignet sich insbesondere dazu, zwei Seiten einer Folie gleichzeitig mit Plasma zu behandeln. Dabei kann die Folie durch einen zwischen den beiden ausgangsseitigen Stirnseiten 10, 110 der piezoelektrischen Transformatoren 1, 101 gebildeten Zwischenraum 12 hindurchgeführt werden. Eine Oberseite der Folie kann dabei dem ersten piezoelektrischen Transformator 1 zugewandt sein und eine Unterseite der Folie kann dem zweiten piezoelektrischen Transformator 101 zugewandt sein. Der erste piezoelektrische Transformator 1 erzeugt ein Plasma, mit dem die Oberseite der Folie behandelt wird, und der zweite piezoelektrische Transformator 101 erzeugt ein Plasma, mit dem die Unterseite der Folie mit Plasma behandelt wird.

Auch die in Figur 5 und Figur 6 gezeigten Ausführungsbeispiele, bei denen die piezoelektrischen Transformatoren 1 zu einer einzigen Zeile oder zu einem Array aufweisend mehrere Spalten und mehrere Zeilen angeordnet sind, können in einer gegenüberliegenden Anordnung ausgeführt werden. Dabei kann eine erste Gruppe von piezoelektrischen Transformatoren entweder eine Zeile oder ein Array bilden und gegenüber einer zweiten Gruppe von piezoelektrischen Transformatoren angeordnet sein, die ebenfalls eine Zeile oder ein Array bilden. Die Transformatoren werden dabei mit einer Eingangsspannung versorgt, wobei zu beachten ist, dass unmittelbar zueinander benachbarte Transformatoren jeweils mit einer zueinander um 90° versetzten Eingangsspannung versorgt werden sollten, dass einander gegenüberliegende Transformatoren ebenfalls mit einer Eingangsspannung versorgt werden sollten, die um 90° zueinander versetzt sind und dass die Transformatoren, die auf einer Diagonalen angeordnet sind, jeweils mit phasengleichen Eingangsspannungen versorgt werden.

### Bezugszeichenliste

- 1: piezoelektrischer Transformator
- 2: Eingangsbereich
- 3: Ausgangsbereich
- 4: Elektrode
- 5: piezoelektrisches Material
- 6: erste Seitenfläche
- 7: zweite Seitenfläche
- 8: erste Außenelektrode
- 9: piezoelektrisches Material
- 10: ausgangsseitige Stirnseite
- 11: Spalt
- 12: Zwischenraum
- 101: zweiter piezoelektrischer Transformator
- 103: Ausgangsbereich
- 110: ausgangsseitige Stirnseite
- 201: dritter piezoelektrischer Transformator
- 301: vierter piezoelektrischer Transformator

- x: Stapelrichtung
- z: longitudinale Richtung

## Patentansprüche

1. Vorrichtung zur Erzeugung eines nichtthermischen Atmosphärendruck-Plasmas aufweisend einen ersten piezoelektrische Transformator (1), einen zweiten piezoelektrische Transformator (101) wobei sich zwischen dem ersten Transformator (1) und dem zweiten Transformator (101) ein Spalt (11) befindet, und eine Ansteuerschaltung, die dazu ausgestaltet ist, an jeden der piezoelektrischen Transformatoren (1, 101) eine Eingangsspannung anzulegen, **dadurch gekennzeichnet, dass** die Eingangsspannung, die an den ersten Transformator (1) angelegt wird, gegenüber der Eingangsspannung, die an den zweiten Transformator (101) angelegt wird, um 90° phasenverschoben ist.

2. Vorrichtung gemäß dem vorherigen Anspruch,
wobei der erste und der zweite piezoelektrische Transformator (1, 101) in einem Abstand von weniger als 5 cm zueinander angeordnet sind.

3. Vorrichtung gemäß einem der vorherigen Ansprüche, wobei die Ansteuerschaltung derart ausgestaltet ist, dass die Eingangsspannungen, die an die piezoelektrischen Transformatoren (1, 101) angelegt werden, jeweils die gleiche Frequenz aufweisen.

4. Vorrichtung gemäß einem der vorherigen Ansprüche, aufweisend weitere piezoelektrische Transformator (201, 301), wobei die Ansteuerschaltung dazu ausgelegt ist, die Eingangsspannungen an die Transformatoren (1, 101, 201, 301) derart anzulegen, dass Eingangsspannungen, die an zueinander unmittelbar benachbarten Transformatoren (1, 101) anliegen, jeweils um 90° zueinander phasenverschoben sind.

5. Vorrichtung gemäß dem vorherigen Anspruch,
wobei die piezoelektrischen Transformatoren (1, 101, 201, 301) parallel zueinander angeordnet sind und eine einzige Zeile bilden.

6. Vorrichtung gemäß dem Anspruch 4,
wobei die piezoelektrischen Transformatoren (1, 101, 201, 301) parallel zueinander angeordnet sind und ein Array mit zumindest zwei Zeilen und zumindest zwei Spalten bilden, und
wobei die Ansteuerschaltung dazu ausgelegt ist, die Eingangsspannungen an die Transformatoren (1, 101, 201, 301) derart anzulegen, dass die Eingangsspannungen, die an den Transformatoren (1, 301) anliegen, die auf ein und derselben Diagonale des Arrays angeordnet sind, jeweils um 0° zueinander phasenverschoben sind.

7. Vorrichtung gemäß einem der Ansprüche 1 bis 4,
wobei der erste und der zweite piezoelektrische Transformator (1, 101)derart angeordnet sind, dass ihre ausgangsseitigen Stirnseiten (10, 110) einander gegenüberliegen.

8. Vorrichtung gemäß einem der Ansprüche 1 bis 4,
wobei eine erste Gruppe von piezoelektrischen Transformatoren den ersten piezoelektrischen Transformator (1) und weitere piezoelektrische Transformatoren aufweist, die parallel zueinander angeordnet sind und eine einzige Zeile bilden, und wobei eine zweite Gruppe von piezoelektrischen Transformatoren, den zweiten piezoelektrischen Transformator (101) und weitere piezoelektrische Transformatoren aufweist, die parallel zueinander angeordnet sind und eine einzige Zeile bilden, wobei die erste Gruppe von piezoelektrischen Transformatoren und die zweite Gruppe von piezoelektrischen Transformatoren einander gegenüberliegend angeordnet ist,
wobei die Ansteuerschaltung dazu ausgelegt ist, die Eingangsspannungen an die Transformatoren einer Zeile jeweils derart anzulegen, dass Eingangsspannungen, die an zueinander unmittelbar benachbarten Transformatoren anliegen, jeweils um 90° zueinander phasenverschoben sind, und dass ferner die Eingangsspannungen, die an einander gegenüberliegenden Transformatoren anliegen, jeweils um 90° zueinander phasenverschoben sind.

9. Vorrichtung gemäß einem der Ansprüche 1 bis 4,
wobei eine erste Gruppe von piezoelektrischen Transformatoren den ersten piezoelektrischen Transformator (1) und weitere piezoelektrische Transformatoren aufweist, die parallel zueinander angeordnet sind und ein Array mit zumindest zwei Spalten und zumindest zwei Zeilen bilden, und
wobei eine zweite Gruppe von piezoelektrischen Transformatoren den zweiten piezoelektrischen Transformator (101) und weitere piezoelektrische Transformatoren aufweist, die parallel zueinander angeordnet sind und ein Array mit zumindest zwei Spalten und zumindest zwei Zeilen bilden,
wobei die erste Gruppe von piezoelektrischen Transformatoren und die zweite Gruppe von piezoelektrischen Transformatoren einander gegenüberliegend angeordnet ist,
wobei die Ansteuerschaltung dazu ausgelegt ist, die Eingangsspannungen an die Transformatoren jeweils derart anzulegen, dass Eingangsspannungen, die an zueinander unmittelbar benachbarten Transformatoren anliegen, jeweils um 90° zueinander phasenverschoben sind, dass die Eingangsspannungen, die an den Transformatoren anliegen, die auf ein und derselben Diagonale des Arrays angeordnet sind, jeweils um 0° zueinander phasenverschoben sind, und dass ferner die Eingangsspannungen, die an einander gegenüberliegenden Transformatoren anliegen, jeweils um 90° zueinander phasenverschoben sind.

10. Vorrichtung gemäß Anspruch 7,
wobei die Vorrichtung zur Durchführung eines zu bearbeitenden Gegenstands durch den Spalt (11), der zwischen den ausgangsseitigen Stirnseiten (10, 110) der beiden Transformatoren (1, 101) ausgebildet ist, ausgestaltet ist.

11. Vorrichtung gemäß Anspruch 10,
wobei die Vorrichtung zur Behandlung zweier einander gegenüberliegender Oberflächen des Gegenstands mit dem nichtthermischen Atmosphärendruck-Plasma ausgestaltet ist.

12. Verfahren zur Erzeugung von nichtthermischem Atmosphärendruck-Plasma mittels zumindest eines ersten piezoelektrischen Transformators (1) und eines zweiten piezoelektrischen Transformators (101), wobei sich zwischen dem ersten Transformator (1) und dem zweiten Transformator (101) ein Spalt (11) befindet, **dadurch gekennzeichnet, dass** an den ersten piezoelektrischen Transformator (1) und an den zweiten piezoelektrischen Transformator (101) jeweils eine Eingangsspannung angelegt wird, die zueinander um 90° phasenverschoben sind.

13. Verfahren gemäß Anspruch 12,
wobei der erste piezoelektrische Transformator (1) und der zweite piezoelektrische Transformator (101) derart angeordnet sind, dass ihre ausgangsseitigen Stirnseiten einander gegenüberliegen.

14. Verfahren gemäß Anspruch 13,
wobei ein zu bearbeitender Gegenstand durch den Spalt, der zwischen den ausgangsseitigen Stirnseiten (10, 110) der beiden piezoelektrischen Transformatoren (1, 101) ausgebildet ist, hindurchgeführt wird.

15. Verfahren gemäß Anspruch 14,
wobei der zu bearbeitender Gegenstand eine Folie ist.

16. Verfahren gemäß Anspruch 14 oder Anspruch 15,
wobei zwei einander gegenüberliegende Oberflächen des Gegenstandes gleichzeitig mit von den piezoelektrischen Transformatoren (1, 101) erzeugtem nichtthermischen Atmosphärendruck-Plasma beaufschlagt werden.

## Claims

1. Apparatus for generating a non-thermal atmospheric-pressure plasma comprising a first piezoelectric transformer (1), a second piezoelectric transformer (101), wherein there is a gap (11) between the first transformer (1) and the second transformer (101), and a drive circuit that is configured to apply an input voltage to each of the piezoelectric transformers (1, 101), **characterized in that** the input voltage that is applied to the first transformer (1) is phase-shifted through 90° in relation to the input voltage that is applied to the second transformer (101).

2. Apparatus according to the preceding claim, wherein the first and second piezoelectric transformers (1, 101) are arranged at a distance of less than 5 cm from one another.

3. Apparatus according to either of the preceding claims, wherein the drive circuit is configured in such a way that the input voltages that are applied to the piezoelectric transformers (1, 101) each have the same frequency.

4. Apparatus according to any of the preceding claims, comprising further piezoelectric transformers (201, 301), wherein the drive circuit is designed to apply the input voltages to the transformers (1, 101, 201, 301) in such a way that input voltages that are present at immediately adjacent transformers (1, 101) are each phase-shifted through 90° with respect to one another.

5. Apparatus according to the preceding claim, wherein the piezoelectric transformers (1, 101, 201, 301) are arranged parallel to one another and form a single row.

6. Apparatus according to Claim 4, wherein the piezoelectric transformers (1, 101, 201, 301) are arranged parallel to one another and form an array with at least two rows and at least two columns, and wherein the drive circuit is designed to apply the input voltages to the transformers (1, 101, 201, 301) in such a way that the input voltages that are present at the transformers (1, 301) that are arranged on one and the same diagonal of the array are each phase-shifted through 0° with respect to one another.

7. Apparatus according to any of Claims 1 to 4, wherein the first and second piezoelectric transformers (1, 101) are arranged in such a way that their output-side end faces (10, 110) are opposite one another.

8. Apparatus according to any of Claims 1 to 4, wherein a first group of piezoelectric transformers comprises the first piezoelectric transformer (1) and further piezoelectric transformers that are arranged parallel to one another and form a single row, and wherein a second group of piezoelectric transformers comprises the second piezoelectric transformer (101) and further piezoelectric transformers that are arranged parallel to one another and form a single row, wherein the first group of piezoelectric transformers and the second group of piezoelectric transformers are arranged opposite one another, wherein the drive circuit is designed to apply the input voltages to each of the transformers of a row in such a way that input voltages that are present at immediately adjacent transformers are each phase-shifted through 90° with respect to one another, and that furthermore the input voltages that are present at transformers that are opposite one another are each phase-shifted through 90° with respect to one another.

9. Apparatus according to any of Claims 1 to 4, wherein a first group of piezoelectric transformers comprises the first piezoelectric transformer (1) and further piezoelectric transformers that are arranged parallel to one another and form an array with at least two columns and at least two rows, and wherein a second group of piezoelectric transformers comprises the second piezoelectric transformer (101) and further piezoelectric transformers that are arranged parallel to one another and form an array with at least two columns and at least two rows, wherein the first group of piezoelectric transformers and the second group of piezoelectric transformers are arranged opposite one another, wherein the drive circuit is designed to apply the input voltages to each of the transformers in such a way that input voltages that are present at immediately adjacent transformers are each phase-shifted through 90° with respect to one another, that the input voltages that are present at the transformers that are arranged on one and the same diagonal of the array are each phase-shifted through 0° with respect to one another, and that furthermore the input voltages that are present at transformers that are opposite one another are each phase-shifted through 90° with respect to one another.

10. Apparatus according to Claim 7, wherein the apparatus is configured for passing an object to be processed through the gap (11) formed between the output-side end faces (10, 110) of the two transformers (1, 101).

11. Apparatus according to Claim 10, wherein the apparatus is configured for treating two mutually opposite surfaces of the object with the non-thermal atmospheric-pressure plasma.

12. Method for generating non-thermal atmospheric-pressure plasma by means of at least one first piezoelectric transformer (1) and a second piezoelectric transformer (101), wherein there is a gap (11) between the first transformer (1) and the second transformer (101), **characterized in that** an input voltage is applied to the first piezoelectric transformer (1) and to the second piezoelectric transformer (101) respectively, the input voltages being phase-shifted through 90° with respect to one another.

13. Method according to Claim 12, wherein the first piezoelectric transformer (1) and the second piezoelectric transformer (101) are arranged in such a way that their output-side end faces are opposite one another.

14. Method according to Claim 13, wherein an object to be processed is passed through the gap formed between the output-side end faces (10, 110) of the two piezoelectric transformers (1, 101).

15. Method according to Claim 14, wherein the object to be processed is a foil.

16. Method according to Claim 14 or Claim 15, wherein two mutually opposite surfaces of the object are simultaneously subjected to non-thermal atmospheric-pressure plasma generated by the piezoelectric transformers (1, 101).

## Revendications

1. Dispositif de génération d'un plasma non thermique à pression atmosphérique, ledit dispositif comportant un premier transformateur piézoélectrique (1), un deuxième transformateur piézoélectrique (101), un espace (11) étant ménagé entre le premier transformateur (1) et le deuxième transformateur (101), et un circuit de commande qui est conçu pour appliquer une tension d'entrée sur chacun des transformateurs piézoélectriques (1, 101), **caractérisé en ce que** la tension d'entrée qui est appliquée sur le premier transformateur (1) est déphasée de 90° par rapport à la tension d'entrée qui est appliquée sur le deuxième transformateur (101).

2. Dispositif selon la revendication précédente, les premier et deuxième transformateurs piézoélectriques (1, 101) étant disposés à une distance inférieure à 5 cm l'un de l'autre.

3. Dispositif selon l'une des revendications précédentes, le circuit de commande étant conçu de manière à que les tensions d'entrée qui sont appliquées sur les transformateurs piézoélectriques (1, 101) ont la même fréquence.

4. Dispositif selon l'une des revendications précédentes, comportant en outre un transformateur piézoélectrique (201, 301), le circuit de commande étant conçu pour appliquer les tensions d'entrée sur les transformateurs (1, 101, 201, 301) de manière à ce que des tensions d'entrée qui sont présentes au niveau des transformateurs (1, 101) qui sont appliquées à des transformateurs immédiatement adjacents les uns aux autres soient déphasées de 90° les unes par rapport aux autres.

5. Dispositif selon la revendication précédente,
les transformateurs piézoélectriques (1, 101, 201, 301) étant disposés parallèlement les uns aux autres et formant une seule ligne.

6. Dispositif selon la revendication 4,
les transformateurs piézoélectriques (1, 101, 201, 301) étant disposés parallèlement les uns aux autres et formant un réseau comprenant au moins deux lignes et au moins deux colonnes, et
le circuit de commande étant conçu pour appliquer les tensions d'entrée sur les transformateurs (1, 101, 201, 301) de manière à ce que les tensions d'entrée, qui sont appliquées sur les transformateurs (1, 301) qui sont disposés sur une seule et même diagonale du réseau, sont déphasées de 0° les unes par rapport aux autres.

7. Dispositif selon l'une des revendications 1 à 4, les premier et deuxième transformateurs piézoélectriques (1, 101) étant disposés de manière à ce que leurs côtés frontaux en sortie (10, 110) sont situés face à face.

8. Dispositif selon l'une des revendications 1 à 4,
un premier groupe de transformateurs piézoélectriques comportant le premier transformateur piézoélectrique (1) et d'autres transformateurs piézoélectriques disposés parallèlement les uns aux autres et formant une seule ligne, et
un deuxième groupe de transformateurs piézoélectriques comportant le deuxième transformateur piézoélectrique (101) et d'autres transformateurs piézoélectriques qui sont disposés parallèlement les uns aux autres et forment une seule ligne,
le premier groupe de transformateurs piézoélectriques et le deuxième groupe de transformateurs piézoélectriques étant disposés l'un face à face,
le circuit de commande étant conçu pour appliquer les tensions d'entrée sur les transformateurs d'une ligne de manière à ce que les tensions d'entrée qui sont appliquées sur des transformateurs immédiatement adjacents les uns aux autres soient déphasées de 90° les unes par rapport aux autres et qu'en outre les tensions d'entrée, qui sont appliquées sur des transformateurs situés face à face, soient déphasées de 90° les unes par rapport aux autres.

9. Dispositif selon l'une des revendications 1 à 4,
un premier groupe de transformateurs piézoélectriques comportant le premier transformateur piézoélectrique (1) et d'autres transformateurs piézoélectriques qui sont disposés parallèlement les uns aux autres et qui forment un réseau comprenant au moins deux colonnes et au moins deux lignes, et
un deuxième groupe de transformateurs piézoélectriques comportant le deuxième transformateur piézoélectrique (101) et d'autres transformateurs piézoélectriques qui sont disposés parallèlement les uns aux autres et qui forment un réseau comprenant au moins deux colonnes et au moins deux lignes,
le premier groupe de transformateurs piézoélectriques et le deuxième groupe de transformateurs piézoélectriques étant disposés face à face,
le circuit de commande étant conçu pour appliquer les tensions d'entrée sur les transformateurs de manière à ce que des tensions d'entrée, qui sont appliquées sur des transformateurs immédiatement adjacents les uns aux autres, soient déphasées de 90° les unes par rapport aux autres, à ce que les tensions d'entrée, qui sont appliquées sur les transformateurs disposés sur une seule et même diagonale du réseau, soient déphasées de 0 ° les unes par rapport aux autres, et à ce qu'en outre les tensions d'entrée, qui sont appliquées sur les transformateurs situés face à face, soient déphasées de 90 ° les unes par rapport aux autres.

10. Dispositif selon la revendication 7,
le dispositif étant conçu pour faire passer un objet à traiter à travers l'espace (11) qui est ménagé entre les côtés frontaux en sortie (10, 110) des deux transformateurs (1, 101).

11. Dispositif selon la revendication 10,
le dispositif étant conçu pour traiter deux surfaces opposées de l'objet avec le plasma non thermique à pression atmosphérique.

12. Procédé de génération de plasma non thermique à pression atmosphérique au moyen d'au moins un premier transformateur piézoélectrique (1) et d'un deuxième transformateur piézoélectrique (101), un espace (11) étant ménagé entre le premier transformateur (1) et le deuxième transformateur (101),
**caractérisé en ce que** des tensions d'entrée, qui sont déphasées de 90° l'une par rapport à l'autre, sont appliquées sur le premier transformateur piézoélectrique (1) et sur le deuxième transformateur piézoélectrique (101).

13. Procédé selon la revendication 12,
le premier transformateur piézoélectrique (1) et le deuxième transformateur piézoélectrique (101) étant disposés de manière à ce que leurs côtés frontaux en sortie sont situés face à face.

14. Procédé selon la revendication 13,
un objet à traiter passant à travers l'espace ménagé entre les côtés frontaux en sortie (10, 110) des deux transformateurs piézoélectriques (1, 101).

15. Procédé selon la revendication 14,
l'objet à traiter étant un film.

16. Procédé selon la revendication 14 ou la revendication 15,
deux surfaces opposées de l'objet étant exposées simultanément à un plasma non thermique à pression atmosphérique généré par les transformateurs piézoélectriques (1, 101).
